# EUROPEAN PATENT SPECIFICATION

(11) **EP 3 002 671 B1**
(45) Date of publication and mention of the grant of the patent: **15.12.2021**
(21) Application number: 15187382.5
(22) Date of filing: 29.09.2015
(51) Int. Cl.: G06F 3/06, G11C 16/34

(54) **METHOD AND SYSTEM FOR IMPROVING FLASH STORAGE UTILIZATION USING READ-THRESHOLD TABLES**
VERFAHREN UND SYSTEM ZUR VERBESSERUNG DER NUTZUNG EINES FLASHSPEICHERS MITTELS VERWENDUNG VON LESESCHWELLENTABELLEN
PROCÉDÉ ET SYSTÈME POUR AMÉLIORER L'UTILISATION DE STOCKAGE FLASH À L'AIDE DE TABLES DE SEUIL DE LECTURE

(30) Priority: 30.09.2014 US 201414501800
(43) Date of publication of application: 06.04.2016
(73) Proprietor: EMC Corporation, Hopkinton, MA 01748 (US)
(72) Inventor: TABRIZI, Haleh, Santa Clara, CA 95054 (US); AGARWAL, Rajiv, Santa Clara, CA 95054 (US); BARRIENTOS, Michael Francis, Santa Clara, CA 95054 (US); FERREIRA, Jeffrey Paul, Santa Clara, CA 95054 (US); BONWICK, Jeffrey S., Santa Clara, CA 95054 (US); SHAPIRO, Michael W., Santa Clara, CA 95054 (US)
(74) Representative: Sharman, Thomas Alexander

(56) References cited:
- US-A1- 2013 094 286
- US-B1- 8 259 506
- None

## Description

One important performance metric for a storage system is the latency related to retrieving data stored in the storage system. The performance of the storage system improves with a decrease in the read latency. The read latency for a storage system may be decreased if the storage system is able to reliably retrieve error-free data from the storage medium. When error-free data is not retrieved, the storage system may perform additional actions in order to remove the errors from the retrieved data. For example, the storage system may use error correction mechanisms such as error correcting codes (ECC) and/or RAID to remove errors from the retrieved data or otherwise generate error-free data. The use of error correcting mechanisms results in an increase in read latency, which is accompanied with a corresponding decrease in performance. Patent document US 8 259 506 B1 discloses a method for determining a read threshold associated with a first page in an erasure block. The method includes retrieving a stored set of read thresholds that is associated with a second page and adapting the retrieved set of read thresholds to match the first page and reading the first page using the adapted set of read thresholds.

### SUMMARY

In general, in one aspect, the invention relates to a method for reading data from persistent solid-state storage according to claim 1.

In at least one unclaimed aspect, the P/E cycle value is a P/E cycle value range.

In general, in one aspect, the invention relates to a system according to claim 8.

In at least one embodiment, the persistent solid-state storage comprises flash memory and the physical page is located in the flash memory. In at least one unclaimed aspect, the flash memory is one selected from a group consisting of NOR flash memory and NAND flash memory.

In at least one embodiment, the in-memory data structure comprising a plurality of entries.

In at least one unclaimed aspect, the memory comprises a birth time for all data stored in the persistent storage; and determining the retention time for the data stored on the physical page comprises obtaining a birth time for the data stored on the physical page from the memory.

In general, in one aspect, the invention relates to a non-transitory computer readable medium according to claim 10.

Other aspects of the invention will be apparent from the following description and the appended claims.

### BRIEF DESCRIPTION OF DRAWINGS

FIGS. 1A-1C show systems in accordance with one or more embodiments of the invention.
FIG. 2 shows storage appliances in accordance with one or more embodiments of the invention.
FIG. 3 shows a storage module in accordance with one or more embodiments of the invention.
FIG. 4 shows the relationship between various components in accordance with one or more embodiments of the invention.
FIGS. 5A-5B show methods for reading data from a storage module in accordance with one or more embodiments of the invention.
FIGS. 6A-6B show examples in accordance with one or more embodiments of the invention.

### DETAILED DESCRIPTION

Specific embodiments of the invention will now be described in detail with reference to the accompanying figures. In the following detailed description of embodiments of the invention, numerous specific details are set forth in order to provide a more thorough understanding of the invention. However, it will be apparent to one of ordinary skill in the art that the invention may be practiced without these specific details. In other instances, well-known features have not been described in detail to avoid unnecessarily complicating the description

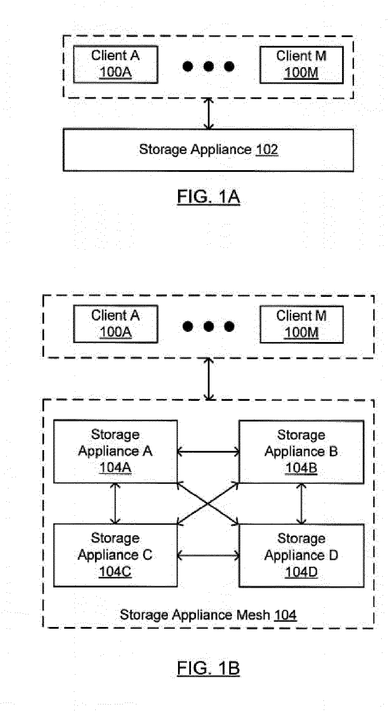

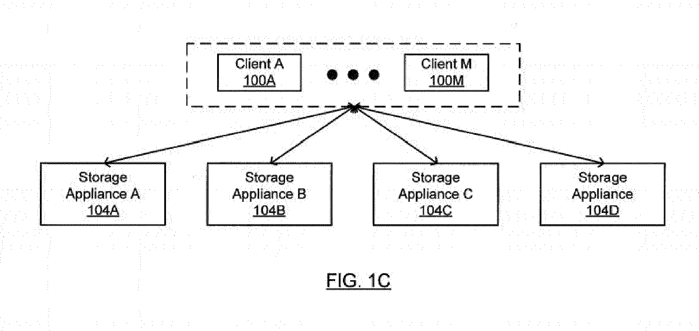

In the following description of FIGS. 1-6B, any component described with regard to a figure, in various embodiments of the invention, may be equivalent to one or more like-named components described with regard to any other figure. For brevity, descriptions of these components will not be repeated with regard to each figure.

In general, embodiments of the invention relate to increasing the utilization of solid-state storage by dynamically modifying read threshold values over the lifetime of the flash storage. More specifically, embodiments of the invention relates to using P/E cycle values, retention times, and page numbers in order to determine the appropriate read threshold value(s) to use when reading data that has been previously stored in the solid-state storage. The ability to dynamically change the read threshold values on a per read request basis allows for more error-free data to be retrieved from the solid-state storage. When error-free data is retrieved from the solid-state storage, there is no need to implement error correction mechanisms. As a result, the performance of the system increases.

The following description describes one or more systems and methods for implementing one or more embodiments of the invention.

FIGS. 1A-1C show systems in accordance with one or more embodiments of the invention. Referring to FIG. 1A, the system includes one or more clients (client A (100A), client M (100M)) operatively connected to a storage appliance (102).

In one embodiment of the invention, clients (100A, 100M) correspond to any physical system that includes functionality to issue a read request to the storage appliance (102) and/or issue a write request to the storage appliance (102). Though not shown in FIG. 1A, each of the clients (100A, 100M) may include a client processor (not shown), client memory (not shown), and any other software and/or hardware necessary to implement one or more embodiments of the invention.

In one embodiment of the invention, the client (100A-100M) is configured to execute an operating system (OS) that includes a file system. The file system provides a mechanism for the storage and retrieval of files from the storage appliance (102). More specifically, the file system includes functionality to perform the necessary actions to issue read requests and write requests to the storage appliance. The file system also provides programming interfaces to enable the creation and deletion of files, reading and writing of files, performing seeks within a file, creating and deleting directories, managing directory contents, etc. In addition, the file system also provides management interfaces to create and delete file systems. In one embodiment of the invention, to access a file, the operating system (via the file system) typically provides file manipulation interfaces to open, close, read, and write the data within each file and/or to manipulate the corresponding metadata.

Continuing with the discussion of FIG. 1A, in one embodiment of the invention, the clients (100A, 100M) are configured to communicate with the storage appliance (102) using one or more of the following protocols: Peripheral Component Interconnect (PCI), PCI-Express (PCIe), PCI-eXtended (PCI-X), Non-Volatile Memory Express (NVMe), Non-Volatile Memory Express (NVMe) over a PCI-Express fabric, Non-Volatile Memory Express (NVMe) over an Ethernet fabric, and Non-Volatile Memory Express (NVMe) over an Infiniband fabric. Those skilled in the art will appreciate that the invention is not limited to the aforementioned protocols.

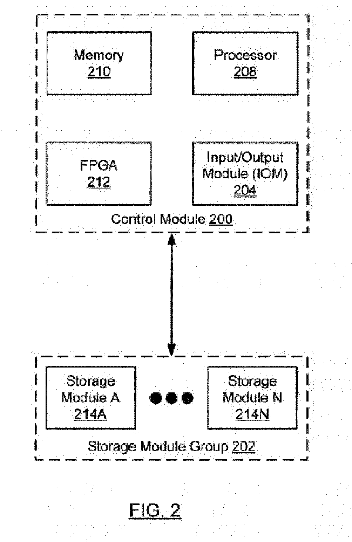

In one embodiment of the invention, the storage appliance (102) is a system that includes volatile and persistent solid-state storage and is configured to service read requests and/or write requests from one or more clients (100A, 100M). Various embodiments of the storage appliance (102) are described below in FIG. 2.

Referring to FIG. 1B, FIG. 1B shows a system in which clients (100A, 100M) are connected to multiple storage appliances (104A, 104B, 104C, 104D) arranged in a mesh configuration (denoted as storage appliance mesh (104) in FIG. 1B). As shown in FIG. 1B, the storage appliance mesh (104) is shown in a fully-connected mesh configuration - that is, every storage appliance (104A, 104B, 104C, 104D) in the storage appliance mesh (104) is directly connected to every other storage appliance (104A, 104B, 104C, 104D) in the storage appliance mesh (104). In one embodiment of the invention, each of the clients (100A, 100M) may be directly connected to one or more storage appliances (104A, 104B, 104C, 104D) in the storage appliance mesh (104). Those skilled in the art will appreciate that the storage appliance mesh may be implemented using other mesh configurations (e.g., partially connected mesh).

Referring to FIG. 1C, FIG. 1C shows a system in which clients (100A, 100M) are connected to multiple storage appliances (104A, 104B, 104C, 104D) arranged in a fanout configuration. In this configuration, each client (100A, 100M) is connected to one or more of the storage appliances (104A, 104B, 104C, 104D); however, there is no communication between the individual storage appliances (104A, 104B, 104C, 104D).

Those skilled in the art will appreciate that while FIGS. 1A-1C show storage appliances connected to a limited number of clients, the storage appliances may be connected to any number of clients. Those skilled in the art will appreciate that while FIGS. 1A-1C show various system configurations, the invention is not limited to the aforementioned system configurations. Further, those skilled in the art will appreciate that the clients (regardless of the configuration of the system) may be connected to the storage appliance(s) using any other physical connection.

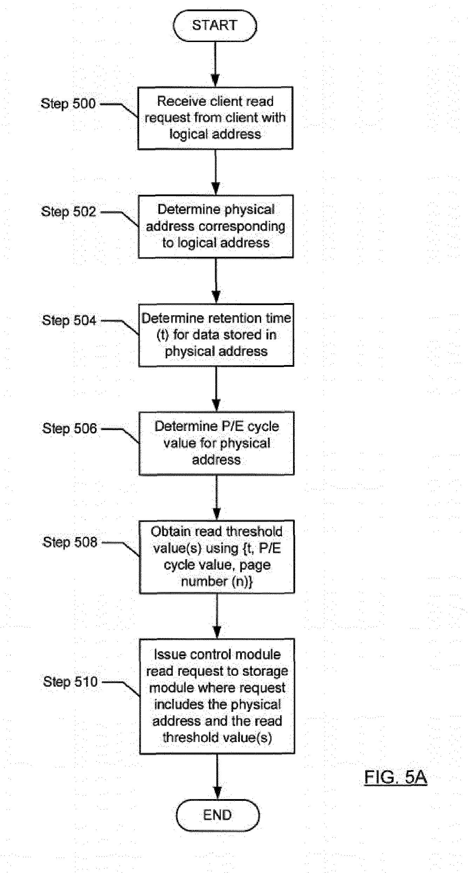

FIG. 2 shows embodiments of a storage appliance in accordance with one or more embodiments of the invention. The storage appliance includes a control module (200) and a storage module group (202). Each of these components is described below. In general, the control module (200) is configured to manage the servicing of read and write requests from one or more clients. In particular, the control module is configured to receive requests from one or more clients via the IOM (discussed below), to process the request (which may include sending the request to the storage module), and to provide a response to the client after the request has been serviced. Additional details about the components in the control module are included below. Further, the operation of the control module with respect to servicing read requests is described below with reference to FIGS. 5A-5B.

Continuing with the discussion of FIG. 2, in one embodiment of the invention, the control module (200) includes an Input/Output Module (IOM) (204), a processor (208), a memory (210), and, optionally, a Field Programmable Gate Array (FPGA) (212). In one embodiment of the invention, the IOM (204) is the physical interface between the clients *(e.g.,* 100A, 100M in FIGs. 1A-1C) and the other components in the storage appliance. The IOM supports one or more of the following protocols: PCI, PCIe, PCI-X, Ethernet (including, but not limited to, the various standards defined under the IEEE 802.3a- 802.3bj), Infiniband, and Remote Direct Memory Access (RDMA) over Converged Ethernet (RoCE). Those skilled in the art will appreciate that the IOM may be implemented using protocols other than those listed above.

Continuing with FIG. 2, the processor (208) is a group of electronic circuits with a single core or multi-cores that are configured to execute instructions. In one embodiment of the invention, the processor (208) may be implemented using a Complex Instruction Set (CISC) Architecture or a Reduced Instruction Set (RISC) Architecture. In one or more embodiments of the invention, the processor (208) includes a root complex (as defined by the PCIe protocol). In one embodiment of the invention, if the control module (200) includes a root complex (which may be integrated into the processor (208)) then the memory (210) is connected to the processor (208) via the root complex. Alternatively, the memory (210) is directly connected to the processor (208) using another point-to-point connection mechanism. In one embodiment of the invention, the memory (210) corresponds to any volatile memory including, but not limited to, Dynamic Random-Access Memory (DRAM), Synchronous DRAM, SDR SDRAM, and DDR SDRAM.

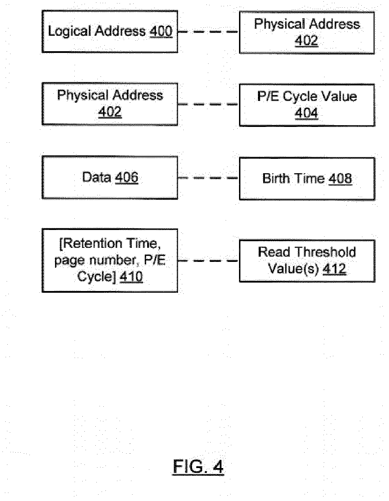

In one unclaimed aspect of the invention, the processor (208) is configured to create and update an in-memory data structure (not shown), where the in-memory data structure is stored in the memory (210). In one embodiment of the invention, the in-memory data structure includes information described in FIG. 4.

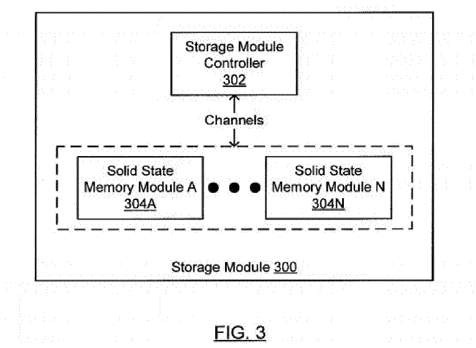

In one unclaimed aspect of the invention, the processor is configured to offload various types of processing to the FPGA (212). In one embodiment of the invention, the FPGA (212) includes functionality to calculate checksums for data that is being written to the storage module(s) and/or data that is being read from the storage module(s). Further, the FPGA (212) may include functionality to calculate P and/or Q parity information for purposes of storing data in the storage module(s) using a RAID scheme (e.g., RAID 2 - RAID 6) and/or functionality to perform various calculations necessary to recover corrupted data stored using a RAID scheme (e.g., RAID 2 - RAID 6). In one embodiment of the invention, the storage module group (202) includes one or more storage modules (214A, 214N) each configured to store data. One embodiment of a storage module is described below in FIG. 3.

FIG. 3 shows a storage module in accordance with one or more embodiments of the invention. The storage module (300) includes a storage module controller (302), memory (not shown), and one or more solid-state memory modules (304A, 304N). Each of these components is described below.

In one embodiment of the invention, the storage module controller (300) is configured to receive requests to read from and/or write data to one or more control modules. Further, the storage module controller (300) is configured to service the read and write requests using the memory (not shown) and/or the solid-state memory modules (304A, 304N).

In one embodiment of the invention, the memory (not shown) corresponds to any volatile memory including, but not limited to, Dynamic Random-Access Memory (DRAM), Synchronous DRAM, SDR SDRAM, and DDR SDRAM.

In one embodiment of the invention, the solid-state memory modules correspond to any data storage device that uses solid-state memory to store persistent data. In one embodiment of the invention, solid-state memory may include, but is not limited to, NAND Flash memory and NOR Flash memory. Further, the NAND Flash memory and the NOR flash memory may include single-level cells (SLCs), multi-level cell (MLCs), or triple-level cells (TLCs). Those skilled in the art will appreciate that embodiments of the invention are not limited to storage class memory.

FIG. 4 shows the relationship between various components in accordance with one or more embodiments of the invention. More specifically, FIG. 4 shows the various types of information that is stored in the memory of the control module. Further, the control module includes functionality to update the information stored in the memory of the control module. The information described below may be stored in one or more in-memory data structures. Further, any data structure type (e.g., arrays, linked lists, hash tables, etc.) may be used to organize the following information within the in-memory data structure(s) provided that the data structure type(s) maintains the relationships (as described below) between the information.

The memory includes a mapping of logical addresses (400) to physical addresses (402). In one embodiment of the invention, the logical address (400) is an address at which the data appears to reside from the perspective of the client *(e.g.,* 100A, 100M in FIG. 1A). Said another way, the logical address (400) corresponds to the address that is used by the file system on the client when issuing a read request to the storage appliance.

In one embodiment of the invention, the logical address is (or includes) a hash value generated by applying a hash function (e.g., SHA-1, MD-5, etc.) to an n-tuple, where the n-tuple is <object ID, offset ID>. In one embodiment of the invention, the object ID defines a file and the offset ID defines a location relative to the starting address of the file. In another embodiment of the invention, the n-tuple is <object ID, offset ID, birth time>, where the birth time corresponds to the time when the file (identified using the object ID) was created. Alternatively, the logical address may include a logical object ID and a logical byte address, or a logical object ID and a logical address offset. In another embodiment of the invention, the logical address includes an object ID and an offset ID. Those skilled in the art will appreciate that multiple logical addresses may be mapped to a single physical address and that the logical address content and/or format is not limited to the above embodiments.

In one embodiment of the invention, the physical address (402) corresponds to a physical location in a solid-state memory module (304A, 304N) in FIG. 3. In one embodiment of the invention, the physical address is defined as the following n-tuple: <storage module, channel, chip enable, LUN, plane, block, page number, byte>.

In one embodiment of the invention, each physical address (402) is associated with a program/erase (P/E) cycle value (404). The P/E cycle value may represent: (i) the number of P/E cycles that have been performed on the physical location defined by the physical address or (ii) a P/E cycle range (e.g., 5,000-9,999 P/E cycles), where the number of P/E cycles that have been performed on the physical location defined by the physical address is within the P/E cycle range. In one embodiment of the invention, a P/E cycle is the writing of data to one or more pages in an erase block *(i.e.,* the smallest addressable unit for erase operations, typically, a set of multiple pages) and the erasure of that block, in either order.

The P/E cycle values may be stored on a per page basis, a per block basis, on a per set of blocks basis, and/or at any other level of granularity. The control module includes functionality to update, as appropriate, the P/E cycle values (402) when data is written to (and/or erased from) the solid-state storage modules.

In one embodiment of the invention, all data *(i.e.,* data that the file system on the client has requested be written to solid-state storage modules) (406) is associated with a birth time (408). The birth time (408) may correspond to: (i) the time the data is written to a physical location in a solid-state storage module (as a result of client write request, as a result of a garbage collection operation initiated by the control module, etc.); (ii) the time that the client issued a write request to write the data to a solid-state storage module; or (iii) a unitless value *(e.g.,* a sequence number) that corresponds to the write events in (i) or (ii).

In one embodiment of the invention, the in-memory data structure includes a mapping of <retention time, page number, P/E cycle value> to one or more read threshold value (412). The aforementioned mapping may further include any other system parameter(s) (*i*.*e*., one or more parameters in addition to retention time, page number, P/E cycle value) that affects the read threshold (e.g., temperature, workload, etc.). In one embodiment of the invention, the retention time corresponds to the time that has elapsed between the writing of the data to a physical location in a solid-state storage module and the time that the data is being read from the same physical location in the solid-state storage module. The retention time may be expressed in units of time or may be expressed as a unitless value (e.g., when the birth time is expressed as a unitless value). In one embodiment of the invention, the P/E cycle value in <retention time, page number, P/E cycle value> may be expressed as a P/E cycle or a P/E cycle range.

In one embodiment of the invention, read threshold value(s) (412) correspond to voltages or a shift value, where the shift value corresponds to a voltage shift of a default read threshold value. Each of read threshold values may be expressed as a voltage or as a unitless number that corresponds to a voltage.

In one embodiment of the invention, the default read threshold value is specified by the manufacturer of the solid-state memory modules. Further, the granularity of the shift values may be specified by the a shift value, where the shift value corresponds to a voltage shift of a corresponding default read threshold value.

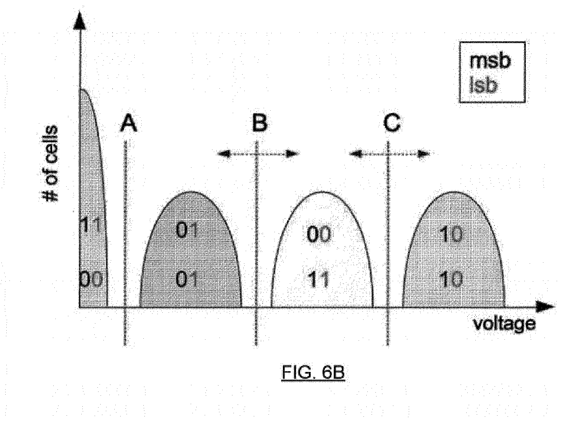

In one embodiment of the invention, the read threshold values (including the default read threshold values) correspond to voltage values that are used to read data stored in solid-state storage modules. More specifically, in one embodiment of the invention, the logical value (e.g., 1 or 0 for memory cells that are SLCs or 00, 10, 11,01 for memory cells that are MLCs) is determined by comparing the voltage in the memory cell to one or more read threshold values. The logical value stored in the memory cell may then be ascertained based the results of the comparison. For example, if a given voltage (V) is above a B threshold and below a C threshold, then the logical value stored in the memory cell is 00 *(see e.g.,* FIG. 6B). In one embodiment of the invention, each page in the solid-state memory module may include between 4-8K of data. Accordingly, the storage module controller typically obtains logical values from multiple memory cells in order to service a read request. The specific number of memory cells from which logical values must be obtained varies based upon the amount of data that is being requested (via the read request) and the type of memory cell (SLC, MLC, etc.).

In one embodiment of the invention, the read threshold value(s) (412) are ascertained by conducting experiments to determine how the read threshold values should be modified when at least one of the following variables is modified: retention time, P/E cycle value, and page number. The read threshold value(s) (412) is optimized in order to be able to successfully read data from a solid-state memory module. Specifically, for each combination of <retention time, P/E cycle value, page number> an optimal read threshold value is determined. The optimal read threshold value for a given <retention time, P/E cycle value, page number> is the read threshold value that results in the lowest bit error rate (BER) in data retrieved from a solid-state memory module for a given retention time of the data, P/E cycle value of the physical location on which the data is stored, and the page number of the page on which the data is stored in the solid-state memory module.

By modifying the read threshold value(s) based upon retention time, P/E cycle value, and page number, the storage appliance takes into account the various variables that may alter the voltage stored in a given memory cell at a given retention time, P/E cycle value, and page number. Said another way, when the logical value "01" is to be stored in a memory cell, the storage module controller stores a sufficient number of electrons in the memory cell in order to have a voltage that corresponds to "01". Over time, the voltage stored in the memory cell varies based upon the retention time, P/E cycle value, and page number. By understanding how the voltage varies over time based on the above variables, an appropriate read threshold value may be used when reading the logical value from the memory cell in order to retrieve "01".

For example, a first read threshold value(s) may be used to successfully read data when the retention time is 4 months, the P/E cycle value is 30,000, and the page number is 3, while a second read threshold value(s) may be used to successfully read data when the retention time is 5 months, the P/E cycle value is 30,000, and the page number is 3.

If the default read threshold value is used (instead of a non-default read threshold value), then there is a higher likelihood that an incorrect logical value (e.g., "11" instead of "01") may be obtained from reading the memory cell. This, in turn, results in the need for ECC or other error correction mechanisms such as RAID reconstruction (*i*.*e*., correction of errors within retrieved data using one or more parity values) in order to correct the error in the retrieve data and ultimately provide error-free data to the requesting client. The use of error correction mechanisms increases the time required to service a client read request and consequently decreases the performance of the storage appliance.

In one embodiment of the invention, a read threshold value(s) may be provided for each <retention time, P/E cycle value, and page number> combination. The specific read threshold value(s) for a given <retention time, P/E cycle value, and page number> may correspond to the default read threshold value(s) or a non-default read threshold value(s) *(i.e.,* a read threshold value other than the default read threshold value(s)).

In another unclaimed aspect of the invention, memory (210 in FIG. 2) only stores a non-default read threshold value(s) for each <retention time, P/E cycle value, and page number> combination that is associated with a non-default read threshold value(s). In this scenario, a non-default read threshold value is associated with a given <retention time, P/E cycle value, and page number> combination when using the non-default read threshold value results in a higher percentage of error-free data being read from the solid-state memory module versus using the default read threshold value(s). Further, in this scenario, no default read threshold value(s) is stored for any <retention time, P/E cycle value, and page number> combination when using the default read threshold value(s) results in a higher percentage of error-free data being read from the solid-state memory module versus using the non-default read threshold value(s).

Turning to the flowcharts, while the various Steps in the flowchart are presented and described sequentially, one of ordinary skill will appreciate that some or all of the Steps may be executed in different orders, may be combined or omitted, and some or all of the steps may be executed in parallel.

FIG. 5A shows a method for processing client read requests by a storage appliance in accordance with one or more embodiments of the invention.

In Step 500, a client read request is received by the control module from a client, where the client read request includes a logical address.

In Step 502, a physical address (which includes the page number) is determined from the logical address. As discussed above, the memory in the control module includes a mapping of logical addresses to physical addresses (see discussion of FIG. 4, 400, 402). In one embodiment of the invention, the physical address is determined by performing a look-up (or query) using the mapping of logical addresses to physical addresses along with the logical address obtained from the client request in Step 500.

In Step 504, the retention time (t) is determined for the data stored at the physical address. In an unclaimed aspect, the retention time may be determined using the birth time of the data (see FIG. 4, 408) and the time of the client request (e.g., the time the client issued the client request, the time the client request was received by the storage appliance, etc.). The birth time of the data is obtained from the memory (e.g., FIG. 2, 210) of the control module. The retention time may be calculated by determining the difference between the time of the client request and the birth time.

In Step 506, the P/E cycle value for the physical address is determined. The P/E cycle value may be determined by performing a look-up in an in-memory data structure (located in the memory of the control module) using the physical address as the key. The result of Step 506 may be the actual P/E cycle value associated with the physical address *(e.g.,* the P/E cycle value associated with the block in which the physical location corresponding to the physical address is located) or may be a P/E cycle value range (e.g., 5,000-9,999 P/E cycles), where the actual P/E cycle value associated with the physical address is within the P/E cycle value range.

In Step 508, a plurality of read threshold values are obtained from an in-memory data structure (see FIG. 4, 410, 412) using the following key <retention time, P/E cycle value, and page number>. In one unclaimed aspect of the invention, the result of Step 508 may be zero read threshold values when the default read threshold value(s) is to be used by the storage module controller to read data from the physical address. As discussed above, the default read threshold value(s) are used when using the default read threshold value(s) results in a higher percentage of error-free data *(i.e.,* data with no bit errors) being read from the solid-state memory module versus using the non-default read threshold value(s). In one embodiment of the invention, one or more non-default threshold values (see FIG. 4, 412) are obtained. As discussed above, the non-default read threshold value(s) is used when using the non-default read threshold value(s) results in a higher percentage of error-free data (*i.e.*, data with no bit errors) being read from the solid-state memory module versus using the default read threshold value(s).

In one embodiment of the invention, the determination of whether to use a non-default read threshold value may be based on the P/E cycle value (determined in Step 506) or the retention time (determined in Step 504). For example, when the P/E cycle value is below a threshold P/E cycle value, the default read threshold value(s) is used and, as such, Step 508 is not performed. Additionally or alternatively, when the retention time is below a threshold retention time, the default read threshold value(s) is used and, as such, Step 508 is not performed. When the P/E cycle value (determined in Step 506) is above the threshold P/E cycle value and/or the retention time (determined in Step 504) is above the threshold retention time then the look-up described in Step 508 is performed.

Continuing with the discussion in FIG. 5A, in Step 510, a control module read request is generated using the plurality of read threshold value(s) obtained in Step 508 and the physical address. In an unclaimed aspect, if there are no read threshold values obtained in Step 508, the control module request may (i) include no read threshold values or (ii) may include one or more default read threshold values, where the control module obtains the default read threshold values in response to no read threshold values being obtained in Step 508. The format of the control module read request may be any format that is supported by the storage module controller.

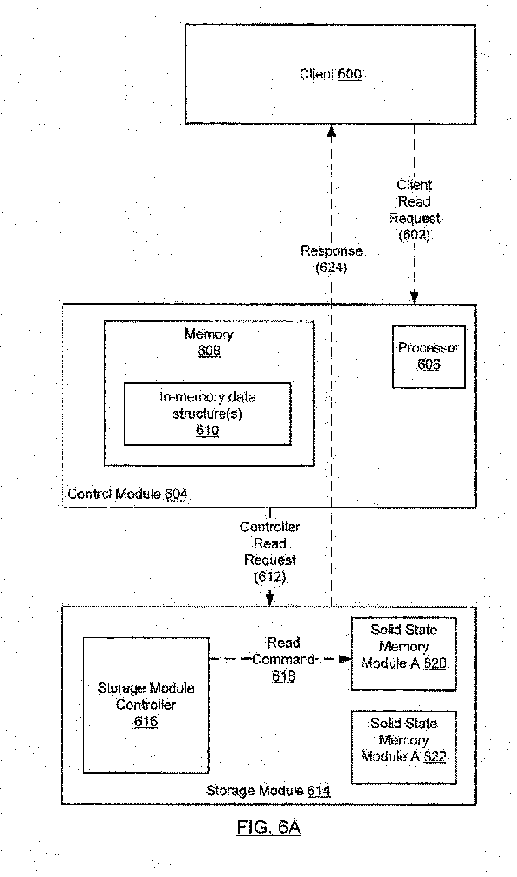

In one embodiment of the invention, if there are multiple read threshold values associated with a given read request (e.g., see FIG. 6B, A threshold value, B threshold value, C threshold value), then at least one the aforementioned threshold values corresponds to the default read threshold value while at least another threshold value corresponds to non-default threshold values. For example, the read threshold values may be <default A read threshold value, non-default B read threshold value, default C read threshold value>. Further, in scenarios in which there are multiple read threshold values, optionally, only the non-default threshold values may be determined in Step 508. For example, the result of Step 508 may be <non-default B threshold value, non-default C threshold value>, which indicates that default A read threshold value should be used along with non-default read threshold values for thresholds B and C.

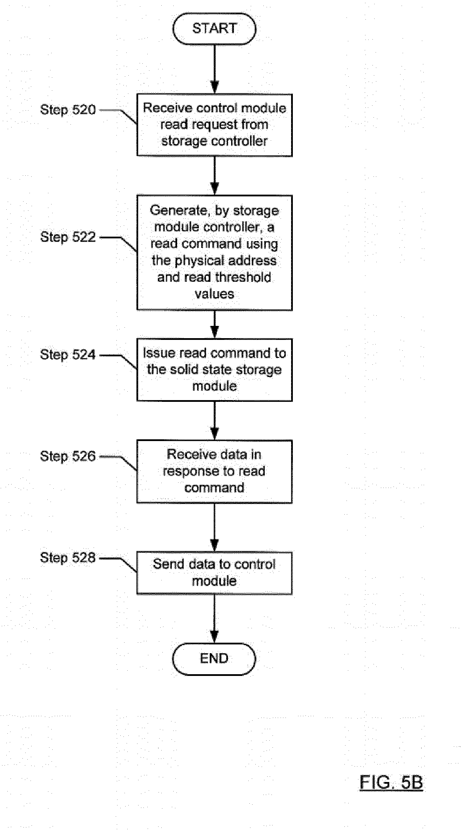

FIG. 5B shows a method for processing control module read requests in accordance with one or more embodiments of the invention. More specifically, FIG. 5B is performed by the storage module controller.

In Step 520, the control module read request is received from the control module. In Step 522, a read command is generated by the storage controller module based on the pluirality of threshold values and the physical address in the control module read request. In one embodiment of the invention any given read command generated in Step 522 may specify one or more read threshold values. In an unclaimed aspect, if the control module does not include any read threshold values then the default read threshold values are used to generate the read command. If the control module read request includes read threshold values that are in the form of shift values (described above), then generating the read command may include obtaining the default read threshold values and modifying one or more read threshold values using the shift value(s). The read command may be in any format that is supported by the solid-state memory modules.

In Step 524, the read command is issued to the solid-state memory module. In Step 526, data is received, by the storage module controller, in response to the read command. In Step 528, the retrieved data is provided to the control module. The control module subsequently provides the data to the client. In one embodiment of the invention, the storage module controller may include functionality to directly transfer the retrieved data to the client without requiring the data to be temporarily stored in the memory on the control module.

FIGS. 6A-6B show examples in accordance with one or more embodiments of the invention. The following examples are not intended to limit the scope of the invention.

Turning to FIG. 6A, consider a scenario in which a client (600) issues a client read request (602), which includes a logical address, to a storage appliance that includes a control module (604) and at least one storage module (614). The control module (604) receives the client read request and generates a controller read request (612) using the method described in FIG. 5A using the processor (606) and one or more in-memory data structures (610) stored in the memory (608) on the control module. More specifically, the control module, using one or more in-memory data structures (610), determines the physical address (PA) that corresponds to the logical address. Further, the control module, using one or more in-memory data structures (610) and the physical address, determines the birth time of the data stored at the physical address. The control module subsequently uses the birth time and the time that the client read request was received in order to determine the retention time of the data stored at the physical address. The control module then performs a look-up in an in-memory data structure(s) using the following index: <retention time, P/E cycle value, page number> in order to obtain at least one read threshold value, where the P/E cycle value is obtained from one of the in-memory data structures and the page number is extracted from the physical address.

In this example assume that the solid-state memory module (620, 622) includes MLCs and that the aforementioned look-up returns read threshold values in the form of shift values for threshold B and threshold C (see FIG. 6B). The control module (604) subsequently generates a controller read request that includes the physical address, a shift value for threshold B and a shift value for threshold C. The controller read request (612) is subsequently issued to the storage module (614) that includes a solid-state memory module (620, 622) that includes the physical location corresponding to the physical address.

The storage module (614) subsequently receives and services the controller read request (612). More specifically, the storage module controller (612) generates and issues a read command (618) to the solid-state memory module that includes the physical location corresponding to the physical address. In this example, the read command is generated using the default read threshold A value, a non-default read threshold B value, and/or a non-default threshold C value. The non-default threshold B value is determined using the default threshold B value and the shift value for threshold B. Further, the non-default threshold C value is determined using the default threshold C value and the shift value for threshold C.

The storage module controller subsequently receives the data from the solid-state memory module and then provides the data (in a response (624)) to the client (600). The data may be directly copied from a memory (not shown) in the storage module to a client memory (not shown).

FIG. 6B shows an example distribution of voltages for a multi-level cell. More specifically, FIG. 6B shows the relative location of threshold values A, B and C in relation to the two different mappings of logical bit values that the voltages represent. In this example, the read threshold values for threshold B and threshold C vary in relation to <retention time, P/E cycle, page number> while the read threshold value does not vary for threshold A.

One or more embodiments of the invention may be implemented using instructions executed by one or more processors in the storage appliance. Further, such instructions may correspond to computer readable instructions that are stored on one or more non-transitory computer readable mediums. According to one or more embodiments, the computer readable medium comprises instructions, which when executed by at least one processor of the system of claim 8 perform a method for reading data from persistent storage according to any embodiment disclosed therein.

While the invention has been described with respect to a limited number of embodiments, those skilled in the art, having benefit of this disclosure, will appreciate that other embodiments can be devised which do not depart from the scope of the appended claims.

## Claims

1. A method for reading data from persistent solid-state storage, the method comprising:
receiving (500) a client read request for data from a client, wherein the client read request comprises a logical address;
determining (502) a physical address corresponding to the logical address, wherein the physical address comprises a page number for a physical page in the persistent solid-state storage;
determining (504), using one address selected from a group consisting of the physical address and the logical address, a retention time for the data stored on the physical page, wherein the retention time corresponds to a time that has elapsed between the writing of the data to a physical location and the time that the data is being read from the same physical location;
determining (506) a program/erase (P/E) cycle value associated with the physical page;
identifying (508) a plurality of read threshold values corresponding to a tuple comprising the P/E cycle value, the retention time, and the page number, wherein identifying the plurality of read threshold values comprises performing a look-up in an in-memory data structure, wherein the plurality of read threshold values are indexed, in the in-memory data structure, by the P/E cycle value, the retention time, and the page number, and wherein the plurality of read threshold values comprises at least one default read threshold value and at least one non-default read threshold value;
issuing (510), by a control module, a control module read request comprising the plurality of read threshold values to a storage module, wherein the storage module comprises the physical page, a storage module controller and a memory;
receiving, by the storage module, the control module read request;
issuing, by the storage module controller, a read command to the memory; and
obtaining the data from the physical page using the plurality of read threshold values.

2. The method of claim 1, further comprising:
receiving a second client read request for second data from the client, wherein the second client read request comprises a second logical address;
determining a second physical address corresponding to the second logical address, wherein the second physical address comprises a second page number for a second physical page in the persistent solid-state storage;
determining, using one address selected from a group consisting of the second physical address and the second logical address, a second retention time for the second data stored on the second physical page;
determining a second P/E cycle value associated with the second physical page;
identifying at least one read threshold value corresponding to a second tuple comprising the second P/E cycle value, the second retention time, and the second page number;
issuing a second control module read request comprising the at least one read threshold value to the storage module, wherein the storage module comprises the second physical page, wherein the second physical page is distinct from the physical page; and
obtaining the second data from the second physical page using the at least one read threshold value.

3. The method of claim 1, wherein the physical page is located on a solid-state module in the storage module, wherein the solid-state module comprises a multi-level cell (MLC).

4. The method of claim 3, wherein the at least one default read threshold value is applied to at least one selected from a group of threshold values consisting of an A threshold value, a B threshold value, and a C threshold value, wherein the at least one non-default threshold value is applied to at least another one selected from the group of threshold values.

5. The method of claim 1, wherein the in-memory data structure comprises a plurality of entries,

6. The method of claim 1, wherein at least one read threshold value of the plurality of read threshold values comprises a voltage value.

7. The method of claim 1, wherein at least one read threshold value of the plurality of read threshold values comprises a shift value, wherein the shift value corresponds to a voltage shift of a default read threshold value.

8. A system, comprising:
a storage module (300) comprising a storage module controller (302) and persistent solid-state storage (304A - 304N); and
a control module (200) operatively connected to the storage module and a client, and comprising an in-memory data structure;
wherein the control module is configured to:
receive (500) a client read request for data from the client, wherein the client read request comprises a logical address;
determine (502) a physical address corresponding to the logical address, wherein the physical address comprises a page number for a physical page in the persistent solid-state storage;
determine (504), using one address selected from a group consisting of the physical address and the logical address, a retention time for the data stored on the physical page, wherein the retention time corresponds to a time that has elapsed between the writing of the data to a physical location and the time that the data is being read from the same physical location;
determine (506) a program/erase (P/E) cycle value associated with the physical page;
identify a plurality of read threshold values corresponding to a tuple comprising the P/E cycle value, the retention time, and the page number, wherein identifying the plurality of read threshold values comprises performing a look-up in the in-memory data structure, wherein the plurality of read threshold values are indexed, in the in-memory data structure, by the P/E cycle value, the retention time, and the page number, and wherein the plurality of read threshold values comprises at least one default read threshold value and at least one non-default read threshold value; and
issue (510) a control module read request comprising the plurality of read threshold values to the storage module, wherein the storage module comprises the physical page;
wherein the storage module is configured to:
receive the control module read request; and
obtain the data from the physical page using the plurality of read threshold values in the control module read request.

9. The system of claim 8 wherein the persistent solid-state storage comprises flash memory and wherein the physical page is located in the flash memory.

10. A non-transitory computer readable medium comprising computer readable program code, which when executed by a computer processor in the system of claim 8 enables the system to:
receive (500) a client read request for data from a client, wherein the client read request comprises a logical address;
determine (502) a physical address corresponding to the logical address, wherein the physical address comprises a page number for a physical page in a persistent solid-state storage;
determine (504), using one address selected from a group consisting of the physical address and the logical address, a retention time for the data, wherein the retention time corresponds to a time that has elapsed between the writing of the data to a physical location and the time that the data is being read from the same physical location;
determine (506) a program/erase (P/E) cycle value associated with the physical page;
identify a plurality of read threshold values corresponding to a tuple comprising the P/E cycle value, the retention time, and the page number, wherein identifying the plurality of read threshold values comprises performing a look-up in an in-memory data structure, wherein the plurality of read threshold values are indexed, in the in-memory data structure, by the P/E cycle value, the retention time, and the page number, and wherein the plurality of read threshold values comprises at least one default read threshold value and at least one non-default read threshold value;
issue (510) a control module read request comprising the plurality of read threshold values to a storage module, wherein the storage module comprises the physical page, a storage module controller, and a memory;
receive, by the storage module, the control module read request;
issue, by the storage module controller, a read command to the memory; and
obtain the data from the physical page using the plurality of read threshold values.

## Patentansprüche

1. Verfahren zum Lesen von Daten aus einem persistenten Festkörperspeicher, wobei das Verfahren Folgendes beinhaltet:
Empfangen (500) einer Client-Leseanforderung für Daten von einem Client, wobei die Client-Leseanforderung eine logische Adresse umfasst;
Bestimmen (502) einer physischen Adresse entsprechend der logischen Adresse, wobei die physische Adresse eine Seitennummer für eine physische Seite im persistenten Festkörperspeicher umfasst;
Bestimmen (504), anhand einer Adresse, ausgewählt aus einer Gruppe bestehend aus der physischen Adresse und der logischen Adresse, einer Aufbewahrungszeit für die auf der physischen Seite gespeicherten Daten, wobei die Aufbewahrungszeit einer Zeit entspricht, die zwischen dem Schreiben der Daten an einen physischen Ort und dem Zeitpunkt verstrichen ist, zu dem die Daten von demselben physischen Ort gelesen werden;
Bestimmen (506) eines mit der physischen Seite assoziierten P/E-(Program/Erase)-Zykluswertes;
Identifizieren (508) mehrerer Leseschwellenwerte entsprechend einem Tupel, das den P/E-Zykluswert, die Aufbewahrungszeit und die Seitennummer umfasst, wobei das Identifizieren der mehreren Leseschwellenwerte das Durchführen eines Nachschlagevorgangs in einer In-Memory-Datenstruktur umfasst, wobei die mehreren Leseschwellenwerte in der In-Memory-Datenstruktur durch den P/E-Zykluswert, die Aufbewahrungszeit und die Seitennummer indiziert sind und wobei die mehreren Leseschwellenwerte mindestens einen Standard-Leseschwellenwert und mindestens einen Nicht-Standard-Leseschwellenwert umfassen;
Ausgeben (510), durch ein Steuermodul, einer die mehreren Leseschwellenwerte umfassenden Steuermodul-Leseanforderung an ein Speichermodul, wobei das Speichermodul die physische Seite, eine Speichermodulsteuerung und ein Memory umfasst;
Empfangen, durch das Speichermodul, der Steuermodul-Leseanforderung;
Ausgeben, durch die Speichermodulsteuerung, eines Lesebefehls an das Memory; und
Gewinnen der Daten von der physischen Seite anhand der mehreren Leseschwellenwerte.

2. Verfahren nach Anspruch 1, das ferner Folgendes beinhaltet:
Empfangen einer zweiten Client-Leseanforderung für zweite Daten von dem Client, wobei die zweite Client-Leseanforderung eine zweite logische Adresse umfasst;
Bestimmen einer zweiten physischen Adresse entsprechend der zweiten logischen Adresse,
wobei die zweite physische Adresse eine zweite Seitennummer für eine zweite physische Seite im persistenten Festkörperspeicher umfasst;
Bestimmen, anhand einer Adresse, ausgewählt aus einer Gruppe bestehend aus der zweiten physischen Adresse und der zweiten logischen Adresse, einer zweiten Aufbewahrungszeit für die auf der zweiten physischen Seite gespeicherten zweiten Daten;
Bestimmen eines zweiten P/E-Zykluswertes, der mit der zweiten physischen Seite assoziiert ist;
Identifizieren mindestens eines Leseschwellenwerts entsprechend einem zweiten Tupel, das den zweiten P/E-Zykluswert, die zweite Aufbewahrungszeit und die zweite Seitennummer umfasst;
Ausgeben einer den mindestens einen Leseschwellenwert umfassenden zweiten Steuermodul-Leseanforderung an das Speichermodul, wobei das Speichermodul die zweite physische Seite umfasst, wobei sich die zweite physische Seite von der physischen Seite unterscheidet; und
Gewinnen der zweiten Daten von der zweiten physischen Seite anhand des mindestens einen Leseschwellenwerts.

3. Verfahren nach Anspruch 1, wobei sich die physische Seite auf einem Festkörpermodul im Speichermodul befindet, wobei das Festkörpermodul eine Multi-Level-Zelle (MLC) umfasst.

4. Verfahren nach Anspruch 3, wobei der mindestens eine Standard-Leseschwellenwert auf mindestens einen Schwellenwert ausgewählt aus einer Gruppe von Schwellenwerten bestehend aus einem A-Schwellenwert, einem B-Schwellenwert und einem C-Schwellenwert angewendet wird, wobei der mindestens eine Nicht-Standard-Schwellenwert auf mindestens einen anderen aus der Gruppe von Schwellenwerten ausgewählten Schwellenwert angewendet wird.

5. Verfahren nach Anspruch 1, wobei die In-Memory-Datenstruktur mehrere Einträge umfasst.

6. Verfahren nach Anspruch 1, wobei mindestens ein Leseschwellenwert der mehreren Leseschwellenwerte einen Spannungswert umfasst.

7. Verfahren nach Anspruch 1, wobei mindestens ein Leseschwellenwert der mehreren Leseschwellenwerte einen Verschiebungswert umfasst, wobei der Verschiebungswert einer Spannungsverschiebung eines Standard-Leseschwellenwertes entspricht.

8. System, das Folgendes umfasst:
ein Speichermodul (300) mit einer Speichermodulsteuerung (302) und einem persistenten Festkörperspeicher (304A - 304N); und
ein Steuermodul (200), das operativ mit dem Speichermodul und einem Client verbunden ist und das eine In-Memory-Datenstruktur umfasst;
wobei das Steuermodul konfiguriert ist zum:
Empfangen (500) einer Client-Leseanforderung für Daten vom Client, wobei die Client-Leseanforderung eine logische Adresse umfasst;
Bestimmen (502) einer physischen Adresse entsprechend der logischen Adresse, wobei die physische Adresse eine Seitennummer für eine physische Seite in dem persistenten Festkörperspeicher umfasst;
Bestimmen (504), anhand einer Adresse, ausgewählt aus einer Gruppe bestehend aus der physischen Adresse und der logischen Adresse, einer Aufbewahrungszeit für die auf der physischen Seite gespeicherten Daten, wobei die Aufbewahrungszeit einer Zeit entspricht, die zwischen dem Schreiben der Daten an einen physischen Ort und dem Zeitpunkt verstrichen ist, zu dem die Daten von demselben physischen Ort gelesen werden;
Bestimmen (506) eines mit der physischen Seite assoziierten P/E-(Program/Erase)-Zykluswertes;
Identifizieren (508) mehrerer Leseschwellenwerte entsprechend einem Tupel, das den P/E-Zykluswert, die Aufbewahrungszeit und die Seitennummer umfasst, wobei das Identifizieren der mehreren Leseschwellenwerte das Durchführen eines Nachschlagevorgangs in der In-Memory-Datenstruktur umfasst, wobei die mehreren Leseschwellenwerte in der In-Memory-Datenstruktur durch den P/E-Zykluswert, die Aufbewahrungszeit und die Seitennummer indiziert sind und wobei die mehreren Leseschwellenwerte mindestens einen Standard-Leseschwellenwert und mindestens einen Nicht-Standard-Leseschwellenwert umfassen; und
Ausgeben (510) einer die mehreren Leseschwellenwerte umfassenden Steuermodul-Leseanforderung an ein Speichermodul, wobei das Speichermodul die physische Seite umfasst;
wobei das Speichermodul konfiguriert ist zum:
Empfangen der Steuermodul-Leseanforderung; und
Gewinnen der Daten von der physischen Seite anhand der mehreren Leseschwellenwerte in der Steuermodul-Leseanforderung.

9. System nach Anspruch 8, wobei der persistente Festkörperspeicher ein Flash-Memory umfasst und wobei sich die physische Seite im Flash-Memory befindet.

10. Nichtflüchtiges computerlesbares Medium mit computerlesbarem Programmcode, der bei Ausführung durch einen Computerprozessor das System nach Anspruch 8 befähigt zum:
Empfangen (500) einer Client-Leseanforderung für Daten von einem Client, wobei die Client-Leseanforderung eine logische Adresse umfasst;
Bestimmen (502) einer physischen Adresse entsprechend der logischen Adresse, wobei die physische Adresse eine Seitennummer für eine physische Seite in einem persistenten Festkörperspeicher umfasst;
Bestimmen (504), anhand einer Adresse, ausgewählt aus einer Gruppe bestehend aus der physischen Adresse und der logischen Adresse, einer Aufbewahrungszeit für die Daten, wobei die Aufbewahrungszeit einer Zeit entspricht, die zwischen dem Schreiben der Daten an einen physischen Ort und dem Zeitpunkt verstrichen ist, zu dem die Daten von demselben physischen Ort gelesen werden;
Bestimmen (506) eines mit der physischen Seite assoziierten P/E-(Program/Erase)-Zykluswertes;
Identifizieren (508) mehrerer Leseschwellenwerte entsprechend einem Tupel, das den P/E-Zykluswert, die Aufbewahrungszeit und die Seitennummer umfasst, wobei das Identifizieren der mehreren Leseschwellenwerte das Durchführen eines Nachschlagevorgangs in einer In-Memory-Datenstruktur umfasst, wobei die mehreren Leseschwellenwerte in der In-Memory-Datenstruktur durch den P/E-Zykluswert, die Aufbewahrungszeit und die Seitennummer indiziert sind und wobei die mehreren Leseschwellenwerte mindestens einen Standard-Leseschwellenwert und mindestens einen Nicht-Standard-Leseschwellenwert umfassen;
Ausgeben (510) einer die mehreren Leseschwellenwerte umfassenden Steuermodul-Leseanforderung an ein Speichermodul, wobei das Speichermodul die physische Seite, eine Speichermodulsteuerung und einen Speicher umfasst;
Empfangen, durch das Speichermodul, der Steuermodul-Leseanforderung;
Ausgeben, durch die Speichermodulsteuerung, eines Lesebefehls an den Speicher; und
Gewinnen der Daten von der physischen Seite anhand der mehreren Leseschwellenwerte.

## Revendications

1. Procédé de lecture de données à partir d'une mémoire persistante à semi-conducteurs, comprenant :
la réception (500) d'une demande de lecture client portant sur des données à partir d'un client, la demande de lecture client comprenant une adresse logique ;
la détermination (502) d'une adresse physique correspondant à l'adresse logique, l'adresse physique comprenant un numéro de page d'une page physique dans la mémoire persistante à semi-conducteurs ;
la détermination (504), à l'aide d'une adresse sélectionnée dans un groupe composé de l'adresse physique et de l'adresse logique, d'une durée de conservation pour les données mémorisées sur la page physique, la durée de conservation correspondant à un temps écoulé entre l'écriture des données dans un emplacement physique et le moment où les données sont lues à partir du même emplacement physique ;
la détermination (506) d'une valeur de cycle de programmation/effacement (P/E) associée à la page physique ;
l'identification (508) d'une pluralité de valeurs de seuil de lecture correspondant à un nuplet comprenant la valeur de cycle P/E, la durée de conservation et le numéro de page, l'identification de la pluralité de valeurs de seuil de lecture comprenant l'exécution d'une consultation dans une structure de données en mémoire, dans lequel la pluralité de valeurs de seuil de lecture est indexée, dans la structure de données en mémoire, par la valeur de cycle P/E, la durée de conservation et le numéro de page, et dans lequel la pluralité de valeurs de seuil de lecture comprend au moins une valeur de seuil de lecture par défaut et au moins une valeur de seuil de lecture non par défaut ;
la délivrance (510), par un module de commande, d'une demande de lecture de module de commande comprenant la pluralité de valeurs de seuil de lecture à un module de mémorisation, le module de mémorisation comprenant la page physique, un contrôleur de module de mémorisation et une mémoire ;
la réception, par le module de mémorisation, de la demande de lecture de module de commande ;
la délivrance, par le contrôleur de module de mémorisation, d'une commande de lecture à la mémoire ; et
l'obtention des données de la page physique à l'aide de la pluralité de valeurs de seuil de lecture.

2. Procédé selon la revendication 1, comprenant en outre :
la réception d'une deuxième demande de lecture client portant sur des deuxièmes données à partir du client, la deuxième demande de lecture client comprenant une deuxième adresse logique ;
la détermination d'une deuxième adresse physique correspondant à la deuxième adresse logique, la deuxième adresse physique comprenant un deuxième numéro de page d'une deuxième page physique dans la mémoire persistante à semi-conducteurs ;
la détermination, à l'aide d'une adresse sélectionnée dans un groupe composé de la deuxième adresse physique et de la deuxième adresse logique, d'une deuxième durée de conservation pour les deuxièmes données mémorisées sur la deuxième page physique ;
la détermination d'une deuxième valeur de cycle P/E associée à la deuxième page physique ;
l'identification d'au moins une valeur de seuil de lecture correspondant à un deuxième nuplet comprenant la deuxième valeur de cycle P/E, la deuxième durée de conservation et le deuxième numéro de page ;
la délivrance d'une deuxième demande de lecture de module de commande comprenant au moins une valeur de seuil de lecture au module de mémorisation, le module de mémorisation comprenant la deuxième page physique, la deuxième page physique étant distincte de la page physique ; et
l'obtention des deuxièmes données de la deuxième page physique à l'aide de l'au moins une valeur de seuil de lecture.

3. Procédé selon la revendication 1, dans lequel la page physique est située sur un module à semi-conducteurs dans le module de mémorisation, le module à semi-conducteurs comprenant une cellule à multiples niveaux (MLC).

4. Procédé selon la revendication 3, dans lequel au moins une valeur de seuil de lecture par défaut est appliquée à au moins une valeur sélectionnée parmi un groupe de valeurs de seuil composé d'une valeur de seuil A, d'une valeur de seuil B et d'une valeur de seuil C, dans lequel l'au moins une valeur de seuil non par défaut est appliquée à au moins une autre valeur sélectionnée dans le groupe de valeurs de seuil.

5. Procédé selon la revendication 1, dans lequel la structure de données en mémoire comprend une pluralité d'entrées.

6. Procédé selon la revendication 1, dans lequel au moins une valeur de seuil de lecture de la pluralité de valeurs de seuil de lecture comprend une valeur de tension.

7. Procédé selon la revendication 1, dans lequel au moins une valeur de seuil de lecture de la pluralité de valeurs de seuil de lecture comprend une valeur de décalage, la valeur de décalage correspondant à un décalage de tension d'une valeur de seuil de lecture par défaut.

8. Système comprenant :
un module de mémorisation (300) comprenant un contrôleur de module de mémorisation (302) et une mémoire persistante à semi-conducteurs (304A - 304N) ; et
un module de commande (200) connecté de manière opérationnelle au module de mémorisation et à un client, et comprenant une structure de données en mémoire,
dans lequel le module de commande est configuré pour :
recevoir (500) une demande de lecture client portant sur des données à partir du client, la demande de lecture client comprenant une adresse logique ;
déterminer (502) une adresse physique correspondant à l'adresse logique, l'adresse physique comprenant un numéro de page d'une page physique dans la mémoire persistante à semi-conducteurs ;
déterminer (504), à l'aide d'une adresse sélectionnée dans un groupe composé de l'adresse physique et de l'adresse logique, une durée de conservation pour les données mémorisées sur la page physique, la durée de conservation correspondant à un temps écoulé entre l'écriture des données dans un emplacement physique et le moment où les données sont lues à partir du même emplacement physique ;
déterminer (506) une valeur de cycle de programmation/effacement (P/E) associée à la page physique ;
identifier une pluralité de valeurs de seuil de lecture correspondant à un nuplet comprenant la valeur de cycle P/E, la durée de conservation et le numéro de page, l'identification de la pluralité de valeurs de seuil de lecture comprenant l'exécution d'une consultation dans une structure de données en mémoire, dans lequel la pluralité de valeurs de seuil de lecture est indexée, dans la structure de données en mémoire, par la valeur de cycle P/E, la durée de conservation et le numéro de page, et dans lequel la pluralité de valeurs de seuil de lecture comprend au moins une valeur de seuil de lecture par défaut et au moins une valeur de seuil de lecture non par défaut ; et
délivrer (510) une demande de lecture de module de commande comprenant la pluralité de valeurs de seuil de lecture dans le module de mémorisation, le module de mémorisation comprenant la page physique ;
dans lequel le module de mémorisation est configuré pour :
recevoir la demande de lecture de module de commande ; et
obtenir les données de la page physique à l'aide de la pluralité de valeurs de seuil de lecture dans la demande de lecture de module de commande.

9. Système selon la revendication 8, dans lequel la mémoire persistante à semi-conducteurs comprend une mémoire flash et dans lequel la page physique est située dans la mémoire flash.

10. Support non transitoire lisible par ordinateur comprenant un code de programme lisible par ordinateur qui, à son exécution par un processeur informatique dans le système selon la revendication 8, permet au système de :
recevoir (500) une demande de lecture client portant sur des données à partir du client, la demande de lecture client comprenant une adresse logique ;
déterminer (502) une adresse physique correspondant à l'adresse logique, l'adresse physique comprenant un numéro de page d'une page physique dans une mémoire persistante à semi-conducteurs ;
déterminer (504), à l'aide d'une adresse sélectionnée dans un groupe composé de l'adresse physique et de l'adresse logique, une durée de conservation pour les données mémorisées sur la page physique, la durée de conservation correspondant à un temps écoulé entre l'écriture des données dans un emplacement physique et le moment où les données sont lues à partir du même emplacement physique ;
déterminer (506) une valeur de cycle de programmation/effacement (P/E) associée à la page physique ;
identifier une pluralité de valeurs de seuil de lecture correspondant à un nuplet comprenant la valeur de cycle P/E, la durée de conservation et le numéro de page, l'identification de la pluralité de valeurs de seuil de lecture comprenant l'exécution d'une consultation dans une structure de données en mémoire, dans lequel la pluralité de valeurs de seuil de lecture est indexée, dans la structure de données en mémoire, par la valeur de cycle P/E, la durée de conservation et le numéro de page, et dans lequel la pluralité de valeurs de seuil de lecture comprend au moins une valeur de seuil de lecture par défaut et au moins une valeur de seuil de lecture non par défaut ; et
délivrer (510) une demande de lecture de module de commande comprenant la pluralité de valeurs de seuil de lecture à un module de mémorisation, le module de mémorisation comprenant la page physique, un contrôleur de module de mémorisation, et une mémoire ;
recevoir, par le module de mémorisation, la demande de lecture de module de commande ;
délivrer, par le contrôleur de module de mémorisation, une commande de lecture à la mémoire ; et ;
obtenir les données de la page physique à l'aide de la pluralité de valeurs de seuil de lecture.
